(19) Europäisches Patentamt
European Patent Office
Office européen des brevets

(11) Publication number: **0 042 632**
**A1**

(12) # EUROPEAN PATENT APPLICATION

(21) Application number: 81200490.1

(22) Date of filing: 08.05.81

(51) Int. Cl.[3]: G 03 F 1/00
G 03 F 7/10, G 03 C 5/00

(30) Priority: 20.06.80 GB 8020167

(43) Date of publication of application: 30.12.81 Bulletin 81/52

(84) Designated Contracting States: BE DE FR GB

(71) Applicant: AGFA-GEVAERT naamloze vennootschap
Septestraat 27
B-2510 Mortsel(BE)

(72) Inventor: Laridon, Urbain Leopold
Damhertenlaan 36
B-2610 Wilrijk(BE)

(72) Inventor: Leenders, Luc Herwig
Broekstraat 7
B-2450 Tielen(BE)

(72) Inventor: Van den Bogaert, Jan Adrianus
De Rest 21
B-2230 Schilde(BE)

(72) Inventor: Heylen, Paul Jozef
Sporthalplein 95
B-2610 Wilrijk(BE)

(54) **Recording material and method for the production of metal images.**

(57) Recording material and method for the production of metallic images by information-wise photoexposure and peel-apart processing. In said material the adherence of a metal layer towards a photosensitive layer in unexposed state is stronger than towards the support so that by overall peeling-apart the exposed photosensitive layer from said support said metal layer can be detached from the support areas corresponding to unexposed areas of the said photosensitive binder layer. The photosensitive layer consists of or contains:
(1) a photosensitive material that is capable of releasing $CO_2$ gas on exposure to actinic radiation and/or
(2) a photosensitive material that is capable of yielding a hydrohalic acid on exposure to actinic radiation.

EP 0 042 632 A1

# Recording material and method for the production of metal images

The present invention relates to a recording material for the production of metal images by information-wise photoexposure and peel-apart processing.

The application of photoadhesion in the recording and reproduction of information by a peel-apart processing is described by Woodruff et al. in Photogr. Sci.Eng., 11, 93 (1967). They discovered that the adhesion of a photopolymerizable layer to a continuous film or support could be changed by photoexposure and called the phenomenon photoadhesion. A selected structure for practical application of photoadhesion comprises a pigmented photopolymer layer between a smooth polyethylene terephthalate cover film and a base film having a roughened surface. The unexposed pigmented photopolymer layer adheres preferentially to the base instead of to the cover film. The photopolymer layer composition is adjusted so that its cohesive strength is greater than the apparent adhesions to the continuous films.

After image-wise exposure to ultraviolet radiation through the cover film the apparent adhesion to the cover film is increased image-wise. On peeling-apart the films an image of photoexposed portions of the pigmented photopolymer layer selectively adheres to the cover film. Such results in a negative image on the cover film and in a positive image on the base.

The pigmenting of the photopolymer layer always gives rise to a reduction of the photosensitivity and therefore recording material structures are preferred wherein the photosensitive element is separate from the element containing the substance(s) responsible for

optical density.

A peel-apart recording material wherein the photosensitive layer is separate from the imaging layer is described in the published German Patent Application (DE-OS) 2,716,422. Said recording material comprises a photosensitive polymeric binder layer incorporating as photosensitive compound benzophenone, a quinone compound, a diazonium compound or an azido compound and is coated onto a metal imaging layer, which in its turn is coated in adhering contact to a support. For use in photodelamination imaging it is essential that the adhering of said photosensitive binder layer in unexposed state is stronger to the metal layer than the adherence of said metal layer to the support. In the photoexposed parts, however, the adhesion is changed in such a way that the photosensitive binder layer loses some of its adherence to the metal layer. On peeling, the structure breaks at the interface metal layer/support in correspondence with the non-photoexposed parts resulting with respect to an original used in the exposure in a positive metal image on the peeled-apart binder layer and in a negative metal image on the support.

Diazonium compounds and azide compounds are known for the photogeneration of nitrogen gas but are unstable and provide explosion hazards on storage and handling. Benzophenone has a low sensitivity for use in peel-apart recording material and quinone compounds are already coloured by themselves so that positive images with non-neutral i.e. coloured image background are obtained.

In accordance with the present invention a novel photosensitive recording material for peel-apart processing is provided wherein a photosensitive binder layer is used that on exposure to actinic radiation undergoes a reduction in adhesive power towards a metal layer.

The present photosensitive recording layer contains photosensitive substances that by exposure to actinic radiation very effectively lower the adherence of said layer towards a metal layer e.g. a vacuum coated aluminium layer.

More particularly the recording material of the present invention being suited for the production of metallic images by information-wise photoexposure and peel-apart processing comprises a support carrying a metal layer in adhering contact therewith, the said metal layer being covered on its outer surface in adhering contact with a photosensitive binder layer that undergoes a reduction in adhering power towards the said metal layer on exposure to actinic light, the adherence of said metal layer towards said photosensitive layer in unexposed state being stronger than towards said support so that by overall peeling-apart of the thus exposed photosensitive layer from the said support said metal layer can be detached from the support areas corresponding to unexposed areas of the said photosensitive binder layer but is otherwise left adhering onto the support, characterized in that the binder of the said photosensitive layer consists of or contains :

(1) a photosensitive material that is capable of releasing $CO_2$ gas on exposure to actinic radiation and/or
(2) a photosensitive material that is capable of yielding a hydrohalic acid on exposure to actinic radiation.

The present method for the production of metal images comprises the steps of

(1) information-wise photoexposing the photosensitive binder layer of the recording material of the present invention to actinic radiation up to a dosage wherein the adhesion of the exposed parts of the photosensitive layer to said metal layer becomes smaller than

the adhesion of the support to said metal layer, and

(2) peeling apart the photosensitive binder layer to detach the metal layer from the support in the non-exposed portions leaving parts of said metal layer corresponding with the photoexposed parts of the photosensitive layer on the support.

The peeling-apart procedure is preferably effected by pulling an adhesive tape or sheet forming before or after the photoexposure an adhered layer to the photosensitive binder layer. The adherence of said adhesive tape or sheet to the photosensitive binder layer has to be strong enough to allow the photosensitive binder layer and the parts of the metal layer corresponding with the unexposed parts of the photosensitive binder layer, together to be peeled away from the support. The required degree of adhesiveness is provided by a large variety of commercially available adhesive tapes or sheets.

When the adhesive tape or sheet is applied before the information-wise photoexposure of the photosensitive binder layer a transparent adhesive tape or sheet is used and the information-wise photoexposure of the photosensitive binder layer proceeds through said tape or sheet.

According to a first embodiment the present recording material contains in the photosensitive binder layer a photosensitive $CO_2$-releasing substance. A preferred substance for said purpose is an organic compound containing at least one oxime ester group of the structure $-\overset{|}{C}=N-O-CO-R$, wherein R is an organic group. An alternative term for "oxime ester" is "O-acyloxime".

Specific oxime esters that can be used as photosensitive $CO_2$-releasing compounds correspond to one of the following general formulae :

$$R^5 - \overset{\displaystyle R^4}{\overset{|}{C}} = N - O - R^6$$

and

$$R^5 - \overset{\displaystyle R^4}{\overset{|}{C}} = N - O - R^7 - O - N = \overset{\displaystyle R^4}{\overset{|}{C}} - R^5$$

wherein :

$R^4$ represents an alkyl group containing 1 or 2 carbon atoms, an aryl group, an alkaryl group, an aralkyl group, a hydroxy-substituted aralkyl group, or an acyl group including a substituted acyl group,

$R^5$ represents one of the groups of $R^4$ or a hydrogen atom,

or wherein $R^4$ and $R^5$ together represent the necessary atoms to form with the adjacent carbon atom a cycloalkyl group, a phenanthrone group, or an indazone group,

$R^6$ represents an acyl group including a substituted acyl group, and

$R^7$ represents a diacyl group.

Preferably at least one of $R^4$ and $R^5$ is an acyl group including a substituted acyl group. The acyl groups for $R^4$, $R^5$ and $R^6$ are preferably acyl groups derived from aliphatic or aromatic carboxylic or sulphonic acids, e.g. benzoyl, phenylsulphonyl, naphthoyl, anthraquinonylcarbonyl, acetyl, propionyl, phenylacetyl, cinnamoyl, alkoxycarbonyl e.g. ethoxycarbonyl and N-substituted carbamoyl e.g. N-phenylcarbamoyl.

Particularly suitable non-polymeric as well as polymeric compounds containing at least one oxime ester group, the so-called oxime esters or O-acyloximes, are those disclosed in the US Patent Specification 3,558,309. Particularly useful are the oxime esters of Table 1.

Table 1

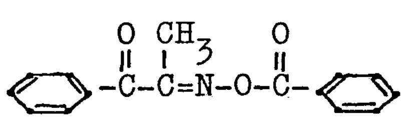

(A)

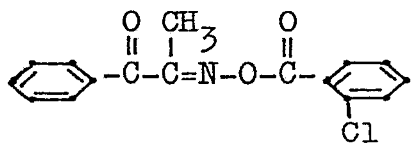

(B)

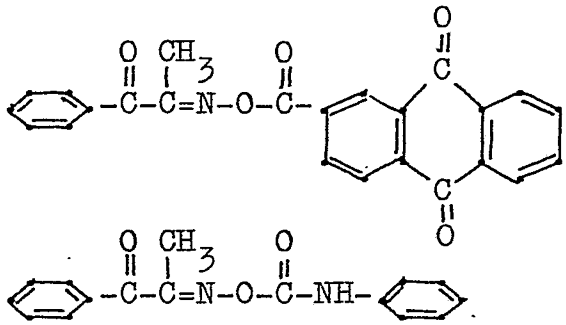

(C)

(D)

Film forming binder polymers comprising oxime-ester groups as integral parts of the main polymer chain for use in photodegradable layers are described in United Kingdom Patent Specification 1,180,845.

The photo-decomposition of such compounds is discussed in the Encyclopaedia of Polymer Science and Technology - Supplement Vol. 1 (1976) John Wiley & Sons Inc. USA p.435 and proceeds with 1-phenyl-1,2-propanedione-2-O-benzoyloxime as follows :

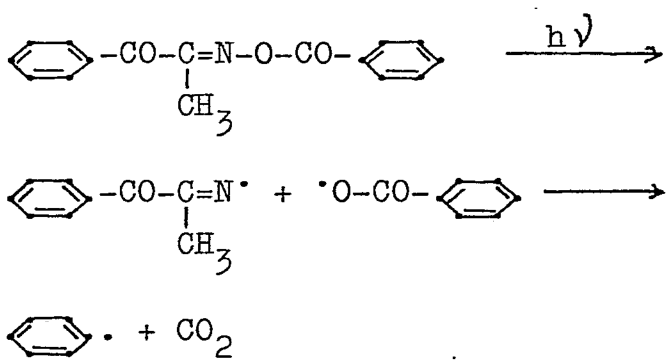


Other useful $CO_2$-releasing compounds are described in the United States Patent Specifications 3,877,941 and 3,918,973.

Still other useful compounds for photochemical $CO_2$-release are nitro compounds from which aci-anion intermediates are produced by photochemical decarboxylation. Examples of such compounds are described in Photogr.Sci.

Eng. Vol. 12 (1968) p.181, e.g. ortho- and para-nitrophenylacetic acid and derivatives thereof. The photodecarboxylation of p-nitrophenylacetic acid proceeds as follows :

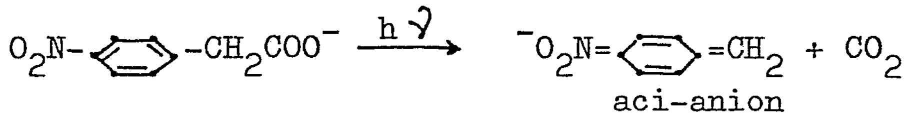


According to a second embodiment the present recording material contains in the photosensitive binder layer a substance capable of yielding (a) halogen radical(s) on exposure to actinic radiation in admixture with a substance acting as hydrogen donor.

A substance capable of yielding halogen radicals on exposure to actinic radiation e.g. UV-radiation is e.g. a homopolymer or copolymer of halogenated α,β-ethylenically unsaturated monomer(s) e.g. is a homopolymer or a copolymer that contains vinyl chloride and/or vinylidene chloride units.

A preferred halogenated copolymer serving also as binder for the photosensitive binder layer is SARAN F 220 (trade mark of The Dow Chemicals Company, Midland, MI, U.S.A. for a copoly(vinylidene chloride/acrylonitrile) (80/20 percent by weight). Said copolymer has a stronger adherence to vacuum coated aluminium than the aluminium has to polyethylene terephthalate.

According to a particular embodiment instead of using an halogenated polymer or copolymer a non-polymeric photohalogen radical-forming organic compound can be used, in combination with halogenated polymer(s) or copolymer(s) or with (an) other binding agent(s) e.g. a non-polymeric compound corresponding to the following general formula :

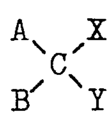

wherein :

each of A, B, X and Y are chlorine, bromine or iodine, or

wherein one of said radicals A, B, X or Y represents an alkyl group including a substituted alkyl group e.g. a halogen substituted alkyl radical, a hydroxyalkyl radical or an aralkyl radical e.g. a benzyl radical, an aryl group including a substituted aryl group or an aroyl group and the other radicals represent chlorine, bromine or iodine, or wherein one or two of said radicals A, B, X or Y represent an aromatic acyl group e.g. a benzoyl group and the other radicals represent chlorine, bromine or iodine.

Suitable representatives falling within the scope of that general formula are carbon tetrabromide, bromoform, iodoform, hexachloroethane, hexabromoethane, pentabromoethane, 1,1,2,2-tetrabromoethane, $\alpha,\alpha,\alpha$-tribromoacetophenone and tribromoethanol.

Suitable hydrogen-donating compounds capable of forming a hydrohalic acid with a photochemically formed halogen radical are, e.g. organic compounds having a hydrogen atom attached to a carbon atom to which a substituent is also attached that greatly weakens the carbon-to-hydrogen bond, thereby rendering the hydrogen atom labile. Compounds of that type are described in the US Patent Specification 3,880,659.

In particular cases the compound yielding halogen radicals at the same time may be the source of labile hydrogen atoms as is the case with polymers containing vinyl chloride units and with iodoform.

Preferred hydrogen-donating compounds are silver halide-reducing agents within the scope of the general formula :

$$R^1-(X^1=X^2)_{n-1}-R^2$$

wherein each of $R^1$ and $R^2$ (same or different) are -OH, $-NH_2$, -NHR or -NRR

$X^1$ is $-\overset{\displaystyle R}{\overset{|}{C}}=$,

$X^2$ is $=\overset{R}{\overset{|}{C}}-$ or =N-, R being an organic group, and n is an integer from 1 to 5.

Examples of these compounds are described by T.H. James in The Theory of the Photographic Process, 4th ed. (1977), Macmillan Publishing Co Inc., p. 299. Other compounds having a labile hydrogen atom and that are very effective in the present process are 4-alkoxy-naphthol compounds, e.g. 4-methoxynaphthol.

Particularly useful results are obtained by using in admixture with said substance capable of photochemically producing (a) halogen radical(s) a compound acting as sensitizing agent by increasing the production of halogen radicals, and/or a compound acting as hydrohalic acid-acceptor by salt formation.

Preferred organic sensitizing compounds that may have one or more of said capacities are described in the United Kingdom Patent Specification 1,359,472 in the classes (C) to (F). Particularly preferred are compounds within the scope of the present classes (A) to (C).

Class (A)

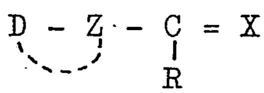 (I)

D-Z-Y-Z-D (II)

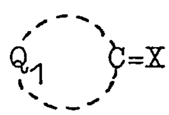 (III)

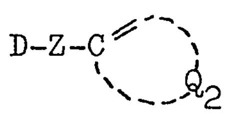 (IV)

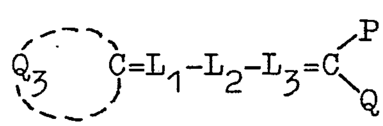 (V)

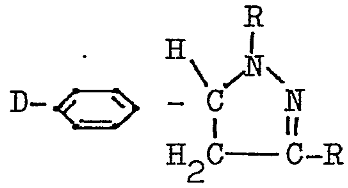

(VI)

wherein :

D represents an electron-donating group being an amino group substituted with alkyl, cycloalkyl or aralkyl, a hydroxy group in which hydrogen is replaced by alkyl, cycloalkyl or aralkyl, or a halogen atom e.g. chlorine or iodine,

Z represents a polymethine chain including a substituted polymethine chain, an azamethine chain including a substituted azamethine chain, phenylene or naphtylene, D and Z optionally being cyclized,

R represents hydrogen, alkyl, aryl, or the necessary atoms to form a homocyclic or heterocyclic ring with an atom of the group Z,

$Q_1$ represents the non-metal atoms necessary to complete a ring or ring system substituted by a group D, this group being linked to the group C=X through a conjugated chain system,

X represents an electronegative atom or group being oxygen, =N-R' wherein R' is hydrogen or an aromatic group, sulphur, selenium or $=C{<}^{CN}_{CN}$,

$Q_2$ represents the necessary atoms to form with the carbon atom of the group $D-Z-C{<}$ a heterocyclic ring having an electronegative character with respect to the group D,

Y represents an electron-attracting group being $-\underset{O}{\overset{}{\underset{\|}{C}}}-\underset{O}{\underset{\|}{C}}-$, $-\underset{O}{\underset{\|}{S}}-$, $-\underset{O\ \ O}{\underset{/\!/\ \backslash\!\backslash}{S}}-$, or the group $-\underset{X}{\underset{\|}{C}}-$ , wherein X has the same meaning as described above,

$Q_3$ represents a heterocyclic nitrogen-containing nucleus, the nitrogen atom(s) of which is/are substituted by an alkyl group,

P and Q each represent an electron-attracting substituent being a cyano group or P and Q together represent the necessary atoms to close a heterocyclic ring with electronegative character such nucleus being present in merocyanine dyes as a ketomethylene ring,

each of $L_1$ and $L_3$ represent a methine group including a substituted methine group, and

$L_2$ represents a monovalent chemical bond, a 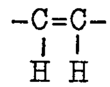 group or a plurality of said groups linked to each other, or $L_1$, $L_2$ and $L_3$ represent together a double bond linking the group

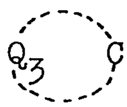 to the group 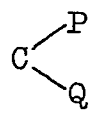,

Class (B)

Polymeric compounds containing recurring units of the following general structure :

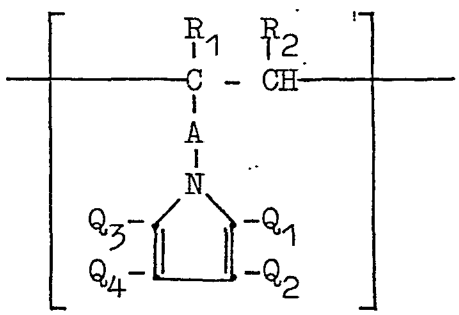

wherein :

A represents a single bond or an alkylene group,

$R_1$ represents hydrogen or a $C_1$-$C_3$ alkyl radical,

$R_2$ represents hydrogen or a $C_1$-$C_3$ alkyl radical,

$Q_1$ and $Q_2$ each represent a hydrogen atom or together the necessary atoms to close an adjacent carbocyclic nucleus including a substituted adjacent carbocyclic nucleus,

$Q_3$ and $Q_4$ each represent a hydrogen atom or together the necessary atoms to close an adjacent carbocyclic

nucleus including a substituted adjacent carbocyclic nucleus, preferably poly-N-vinylcarbazole.

Class (C)

Heterocyclic nitrogen containing compounds having linked to a ring-carbon atom, a thiol group or the tautomeric thione group, as represented in the following structural equation :

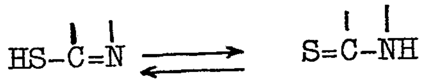

Preferred compounds falling within the scope of formula (I) of class (A) are listed in Table 2.

Table 2

1. 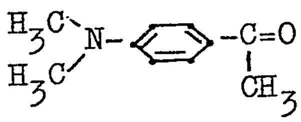

2. 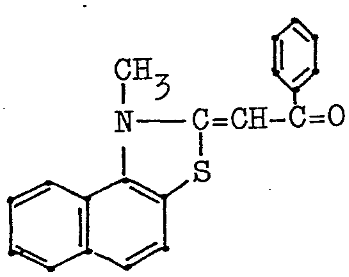

Preferred compounds falling within the scope of formula (II) of class (A) are listed in Table 3.

Table 3

3. 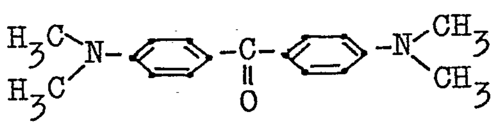

4. 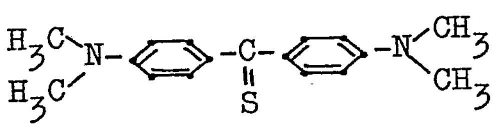

6. 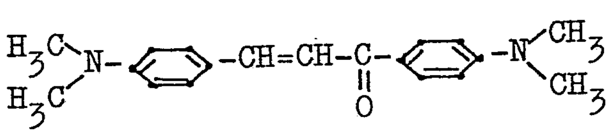

7. 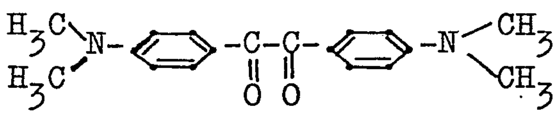

Preferred compounds falling within the scope of formula (III) of class (A) are N-alkylcarbostyrils, described in Belgian Patent Specification 747,849. Representatives thereof are listed in Table 4.

Table 4

8. 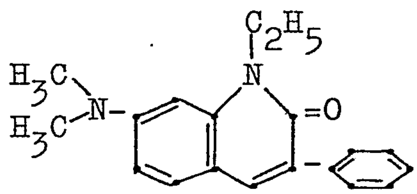

9. 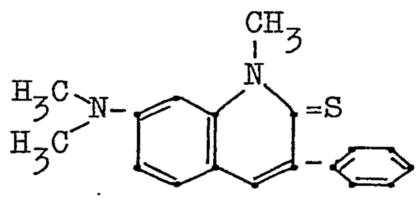

10. 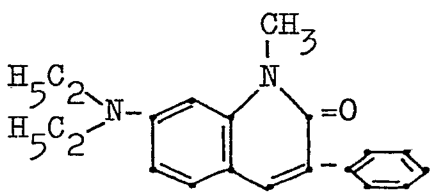

11. 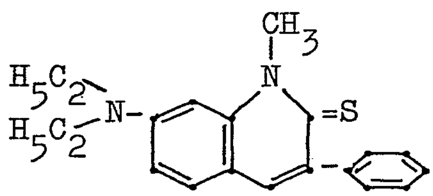

Preferred compounds falling within the scope of formula (IV) of class (A) are styryl dye bases and styrylvinyl dye bases and compounds, e.g. those listed in Table 5.

Table 5

12. 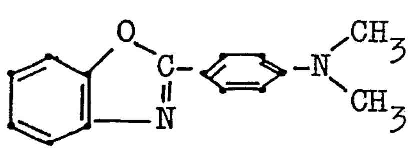

13.

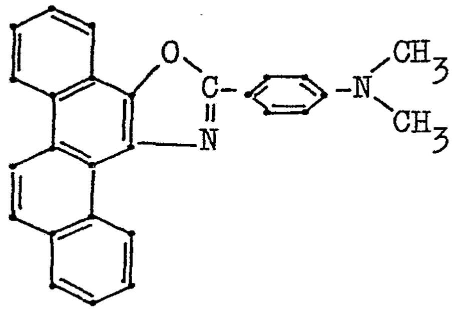

14.

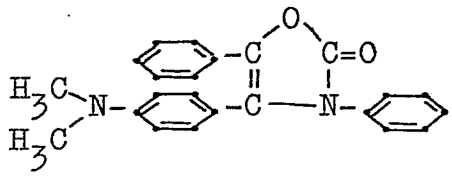

15.

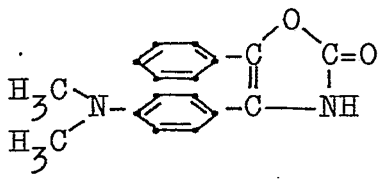

16.

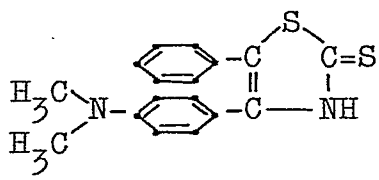

17.

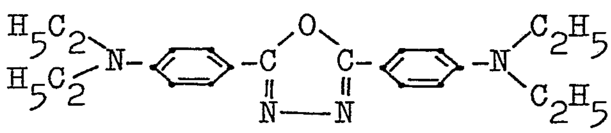

Preferred compounds falling within the scope of formula (VI) of class (A) are listed in Table 6.

Table 6

18.

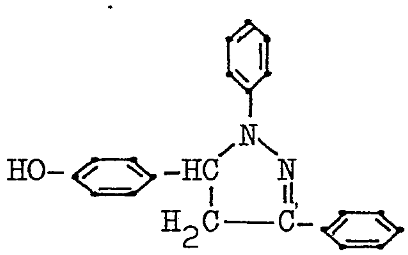

19.

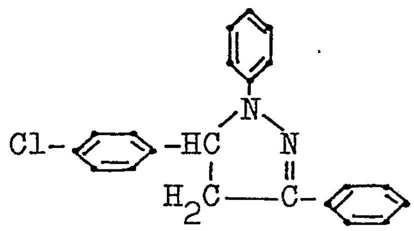

20.

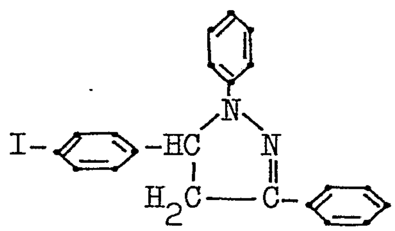

Preferred compounds falling within the scope of formula (V) of class (A) are merocyanines e.g. those described in United Kingdom Patent Specification 1,131,238. Examples thereof are listed in Table 7.

Table 7

21.

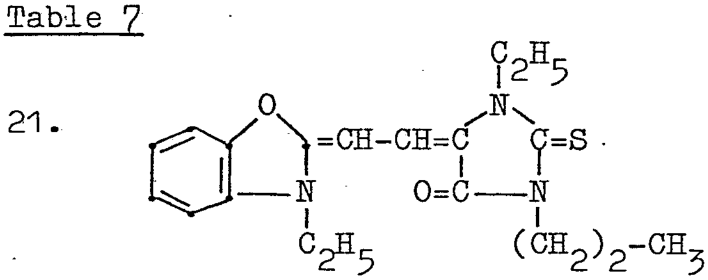

22.

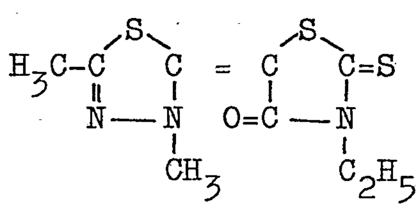

23.

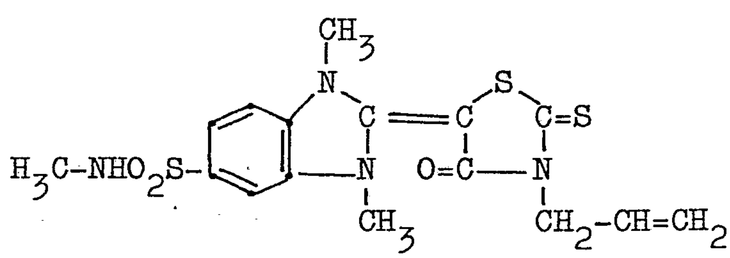

24.

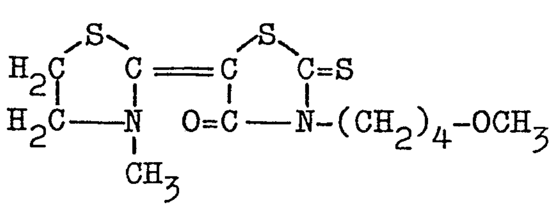

25. 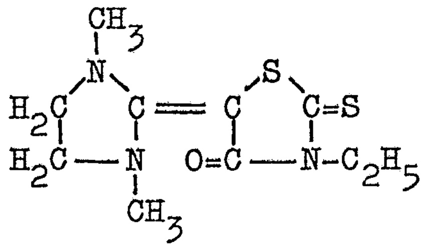

26. 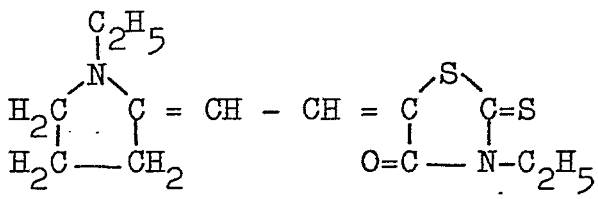

27. 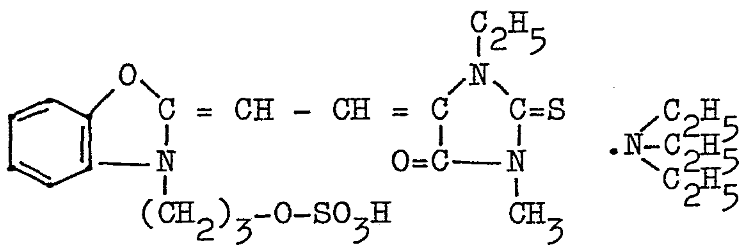

The N-vinyl polymers and copolymers of class (B) can be prepared by application of one of the various known polymerization procedures, e.g., by suspension or emulsion polymerization or by polymerization in solution, whereby the initiation of the polymerization can occur by free radicals, by ion formation, or by radiation e.g., with actinic light. It is to be noted that the molecular weight of the polymer is not critical and can vary between wide limits. As far as the copolymers are concerned, it is further to be noted that the content of groups corresponding to the general formula given hereinbefore is not critical and can vary between wide limits, say, e.g. between 20 and 95 %, taking into account the properties of the compounds used in preparation of the copolymers and the required sensitizing and/or mechanical properties. In general, the best results are attained with copolymers having a content of vinylcarbazole units between 40 and 90 % by weight.

The preparation of suitable poly-N-vinylcarbazoles is described in German Patent Specifications 931,731 - 936,421 - 1,097,680 and 1,158,367, and in United States Patent Specification 2,072,465. The preparation of poly-N-vinyl-pyrrole proceeds analogously.

The preparation of suitable N-vinylcarbazole copolymers is described in United Kingdom Patent Specification 964,875 which specification also contains a preparation recipe for poly(N-allyl carbazole)($R_1$=$CH_3$ and $R_2$=H) and for poly(N-propenyl carbazole)($R_1$=H, $R_2$=H, A=$-CH_2-$).

The poly-N-vinyl indoles are described in published German Patent Specifications 1,906,831 and 1,917,747. The poly-N-vinyl diphenylamine is described in the published German Patent Specification 2,007,692. Halogen-substituted poly-N-vinyl carbazoles are described in published Japanese Patent Specifications 21,875/67, 25,230/67, 7,592/68, 19,751/67 and 7,591/68.

Preferred compounds falling within the scope of class (C) are listed in Table 8.

Table 8

28. 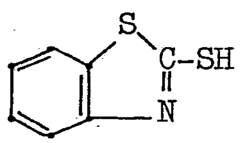

29. 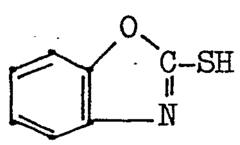

30. 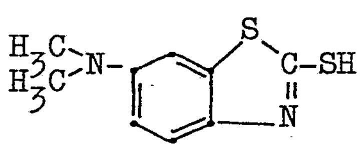

31. 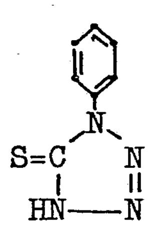

32. 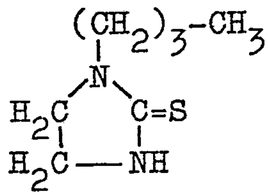

33. 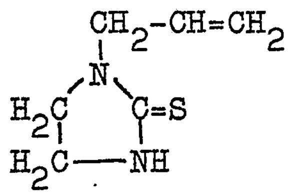

34. 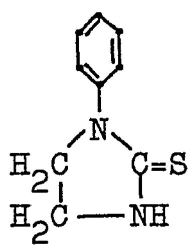

- imidazolidine-4-on-2-thiones, e.g. :

35. 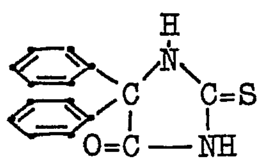

- tetrahydro pyrimidine-2-thiones, e.g. :

36. 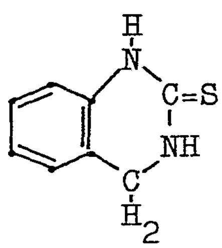

- tetrahydro- and dihydro-oxazine-2-thiones and thiazine-2-thiones, e.g. :

37. 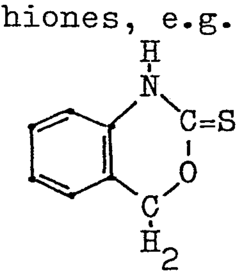

38. 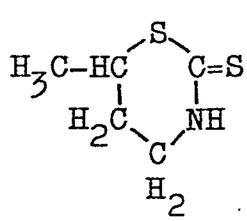

- 1,3,4-dihydro thiadiazine-2-thiones, e.g.

39. 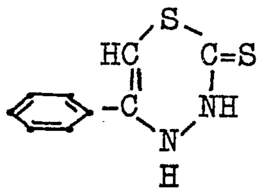

- thiourea compounds including substituted derivatives preferably N-phenyl thiourea compound, e.g. :

40. 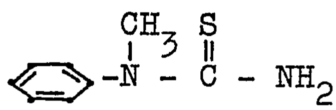

- thioamides, e.g. :

41. 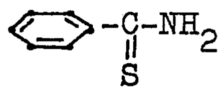

Particularly useful hydrohalic acid-acceptor compounds that by salt formation decrease the adherence of the photosensitive binder layer to the metal layer are basic dye precursor compounds, e.g. carbinol dye bases such as Michler's hydrol forming a triphenylmethane dye with hydrogen halide e.g. HCl. Other useful dye precursors forming a dye salt are 1,3,3-trimethylindolinobenzospiropyrans, and 1,3,3-trimethylindolinonaphthospiropyrans as described in the United Kingdom Patent Specification 1,359,472.

The ratio of binder to substance(s) capable of releasing $CO_2$ gas on exposure to actinic radiation may vary between wide limits and the most suitable ratio can easily be determined by running a series of tests.

Generally the ratio by weight of binder to said $CO_2$-releasing substance(s) is comprised between 1:1 and 10:1. The same applies for the ratio of binder to the compound(s) capable of yielding halogen radicals. The compound(s) capable of yielding halogen radicals which compound(s) may have binder properties, i.e. form

the binder itself, is (are) used in admixture with at least one hydrogen donating substance in a ratio by weight which is comprised e.g. between 0.5:1 and 10:1. The above sensitizing agents that may act as substances enhancing the photoproduction of halogen radicals and/or act as acid acceptor by salt formation with an halide acid are used with respect to the compound(s) producing halogen radicals in a ratio by weight between e.g. 0.5:10 and 5:10.

The support whereon the metal layer is applied is e.g. a resin support whereto the metal layer adheres less strongly than to the photosensitive layer in unexposed state. A particularly suited support for that purpose is a polyethylene terephthalate film support.

In order to produce the present photosensitive recording material a metal coated base or support is coated with a solution of the above substances (1) and/or (2), together with a binder if (1) and (2) does not form the binder itself in a solvent thereof. After the coating the solvent(s) are removed by evaporation.

The coating of the photosensitive binder layer may proceed by a known coating technique, e.g. by spin-coating, whirl-coating, spraying, dip-coating, rollercoating, air-knife coating, doctor-blade coating, etc.

The thickness of the dried photosensitive recording layer is preferably in the range of 0.5 to 5 µm.

The choice of the binding agent(s) i.e. the binder has to be such that the photosensitive layer in unexposed state adheres more strongly to the metal layer than the metal layer adheres to the support e.g. a polyethylene terephthalate support. A suitable binder for that purpose is the already mentioned SARAN F 220 (trade mark) and copolymers of vinyl chloride, vinyl acetate and maleic anhydride the major part (>50 % by

weight) of which is composed of vinyl chloride units.

Other suitable binders in that respect are polycarbonates e.g. the polycarbonate of 2,2-(4,4'-dihydroxydiphenyl)-propane (Bisphenol A).

The metal layer which represents the visibly detectable imaging substance is preferably a smooth nonporous vacuum coated metal layer. Metals preferred for producing such layer are aluminium and nickel.

The thickness of the metal layer is preferably in the range of 0.05 µm to 0.50 µm.

The adhesive material for effecting the peel-apart processing may be any commercial pressure and/or heat sensitive tape or sheet that adheres sufficiently well to the photosensitive binder layer to allow the peel-apart of that binder layer together with the metal parts corresponding with the non-photoexposed parts of that binder layer.

A SCOTCH (trade mark) adhesive tape of Minnesota Mining and Mfg. Co (3M) and TESA-film I and IV being adhesive films comprising an adhesive layer on a clear hydrated cellulose base and polyvinyl chloride base respectively are particularly suitable. TESA is a trade mark of Beiersdorf AG, Tesa-Abt., Annastrasse 48, 2000 Hamburg, W.Germany.

Another suited adhesive material for mounting photographs is known under the trade mark SELLOTAPE of Sellotape Products U.K.

The photoexposure of the photosensitive layer may be an exposure through a contacting transparent master pattern e.g. graphic original,or a projection exposure. The present recording material is suitable for the reproduction of all kinds of text, line or screen image originals and may be used for making advertising panels and conductive circuits by dry peel-apart processing.

The exposure of the photosensitive binder layer may proceed through the adhesive tape or film e.g. in a contact exposure. Such requires that the adhesive tape or film is transparent to the actinic radiation used in the exposure. By actinic radiation is understood here any electromagnetic radiation that can effect the desired change in adherence power of the photosensitive binder layer. Particularly useful is ultraviolet radiation which is highly effective in the producing of photochemical decomposition reactions.

Suitable radiation has therefore a wavelength of 250-400 nm. Suitable radiation sources include carbon arcs, mercury vapour lamps, fluorescent lamps, argon glow lamps, photographic flood lamps and tungsten lamps. Moreover, ordinary daylight may also be used. Pulsed xenon lamps and tungsten lamps emitting to a minor amount in the ultraviolet region and mainly in the visible light range may likewise be used since some of the sensitizers such as the merocyanine dyes extend spectral absorption into the visible light range.

The peel-apart processing proceeds preferably at room temperature (20°C) but it may be advantageous especially where $CO_2$ gas is produced in the photosensitive binder layer to effect the peel-apart processing at elevated temperature e.g. between 50° and 100°C.

The invention is illustrated by the following examples without, however, limiting it thereto. All ratios and percentages are by weight unless otherwise indicated.

Example 1

To a polyethylene terephthalate support carrying a vacuum-coated aluminium layer with an optical density of 2.5 a photosensitive layer was applied at a wet coating thickness of 50 µm from a solution containing the following ingredients :

| | | |
|---|---|---|
| compound (A) of Table 1 | 0.2 | g |
| SARAN F 220 (trade mark) | 1 | g |
| acetone | 8 | ml |
| 1,2-dichloroethane | 2 | ml |
| methyl ethyl ketone | 10 | ml |

After drying at 80°C for 5 min a transparent adhesive tape known under the name SELLOTAPE (trade mark) was laminated on the photosensitive layer. The photosensitive layer was exposed for 30 s through the adhesive tape in contact with a graphic art text negative serving as original by means of a SPEKTRA-PROOF (trade mark) apparatus containing a high-pressure mercury vapour lamp of 2000 W doped with iron(III) chloride.

SPEKTRA-PROOF is a Trade Mark of Siegfried Theimer GmbH, 6484 Birstein, Obersotzbach, Federal Republic of Germany.

Thereupon the laminate was dipped into water of 70°C for 1 min and the adhesive tape subsequently peeled apart. At the exposed parts the aluminium coating remained at the polyethylene terephthalate support, whereas at the unexposed parts the aluminium adhering to the photosensitive layer was torn off and formed thereon an aluminium image having the same image values with respect to the original. On the support an aluminium image remained having reversed image values with respect to the original so that the negative original yielded here a positive copy.

Example 2

To the aluminium layer of the support of Example 1 a photosensitive layer was applied at a wet coating thickness of 50 µm from a solution containing the following ingredients :

| | | |
|---|---|---|
| compound (A) of Table 1 | 0.3 | g |
| SARAN F 220 (trade mark) | 1 | g |

| | |
|---|---|
| methyl ethyl ketone | 11 ml |
| 1,2-dichloroethane | 2 ml |

After drying at 80°C for 5 min a transparent adhesive tape as described in Example 1 was laminated on the photosensitive layer.

The image-wise exposure of the photosensitive layer proceeded as described in Example 1 but lasted only 20 s. Thereupon the laminate was dipped into water of 70°C for 45 s and the adhesive tape overall adhering to the photosensitive layer was peeled apart subsequently. A same result as described in Example 1 was obtained.

Example 3

To the aluminium layer of the support of Example 1 a photosensitive layer was applied at a wet coating thickness of 50 µm from a solution containing the following ingredients :

| | | |
|---|---|---|
| compound 2 of Table 2 | 0.025 | g |
| SARAN F 220 (trade mark) | 1 | g |
| acetone | 8 | ml |
| 1,2-dichloroethane | 2 | ml |
| methyl ethyl ketone | 10 | ml |

After drying at 80°C for 5 min a transparent adhesive tape as described in Example 1 was laminated on the photosensitive layer.

The image-wise exposure of the photosensitive layer proceeded as described in Example 1. Thereupon the adhesive tape was peeled apart at room temperature (20°C). A same result as described in Example 1 was obtained. By peeling apart the laminate after heat treatment at 70°C for 10 s it was possible to reduce the time of the photoexposure to 10 s without impairing the image result.

Example 4

To the aluminium layer of the support of Example 1 a photosensitive layer was applied at a wet coating

thickness of 50 µm from a solution containing the following ingredients :

| | | |
|---|---|---|
| 4,4'-bis(dimethylamino)benzhydrol | 0.025 | g |
| SARAN F 220 (trade mark) | 1 | g |
| methyl ethyl ketone | 18 | ml |
| 1,2-dichloroethane | 2 | ml |

After drying at 80°C for 5 min a transparent adhesive tape as described in Example 1 was laminated on the photosensitive layer.

The image-wise exposure of the photosensitive layer proceeded as described in Example 1 but lasted only 20 s. Thereupon the laminate was dipped into water of 70°C for 1 min and the adhesive tape overall adhering to the photosensitive layer was peeled apart subsequently. A same result as described in Example 1 was obtained.

Example 5

To a solution of 1 g of SARAN F 220 (trade mark) in 16 ml of methyl ethyl ketone and 4 ml of 1,2-dichloroethane different amounts of compound 19 of Table 6 were added. The different coating solutions were applied separately at a wet coating thickness of 50 µm to the aluminium layer of the support of Example 1. The obtained samples were dried at 80°C for 5 min and an adhesive tape as described in Example 1 laminated thereon.

Successful imaging proceeded with exposure times (B) combined with peeling apart at room temperature (20°C) or after heating for a time (C) as mentioned in Table 9. In this Table the samples are defined by the added amount (A) of compound 19 of Table 6.

Table 9

| Sample no. | Amount (A) | Exposure time (B) Peeling apart at 20°C | Peeling apart after heat treatment (C) | at 70°C |
|---|---|---|---|---|
| 1 | 0.025 g | 20 s (B) | 10 s (B) | 10 s (C) |
| 2 | 0.1 g | 10 s (B) | 5 s (B) | 5 s (C) |
| 3 | 0.2 g | 5 s (B) | 3 s (B) | 5 s (C) |

Example 6

Example 5 was repeated with the difference that compound 19 of Table 6 was replaced by compound 20 of Table 6. Successful imaging proceeded with exposure times (B) combined with peeling apart at room temperature (20°C) or after heating for a time (C) as mentioned in Table 10. In said Table the different samples are defined by the added amount (A) of compound 20 of Table 6.

Table 10

| Sample no. | Amount (A) | Exposure time (B) Peeling apart at 20°C | Peeling apart after heat treatment (C) | at 70°C |
|---|---|---|---|---|
| 1 | 0.025 g | > 60 s (B) | 30 s (B) | 30 s (C) |
| 2 | 0.1 g | 10 s (B) | 5 s (B) | 10 s (C) |
| 3 | 0.17 g | 5 s (B) | - | - |
| 4 | 0.25 g | 7 s (B) | - | - |

Example 7

To the aluminium layer of the support of Example 1 a photosensitive layer was applied at a wet coating thickness of 50 µm from a solution containing the following ingredients :

| | |
|---|---|
| compound 20 of Table 6 | 0.09 g |
| SARAN F 220 (trade mark) | 0.5 g |

| | | |
|---|---|---|
| methyl ethyl ketone | 10 | ml |
| 1,2-dichloroethane | 1 | ml |

The coated layer was dried at 80°C for 5 min.

The dried photosensitive layer was exposed for 3 s through an original by means of an exposure apparatus as described in Example 1. After the image-wise photoexposure an adhesive tape as defined in Example 1 was laminated to the photosensitive layer. The adhesive tape overall adhering to the photosensitive layer was peeled apart at room temperature. A negative aluminium image was obtained on the support and a positive aluminium image on the photosensitive layer that was peeled apart with the tape.

Example 8

To the aluminium layer of the support of Example 1 a photosensitive layer was applied at a wet coating thickness of 50 µm from a solution containing the following ingredients :

| | | |
|---|---|---|
| compound 8 of Table 4 | 0.01 | g |
| SARAN F 220 (trade mark) | 1 | g |
| methyl ethyl ketone | 10 | ml |
| acetone | 8 | ml |
| 1,2-dichloroethane | 2 | ml |

After drying at 80°C for 5 min a transparent adhesive tape as described in Example 1 was laminated on the photosensitive layer. The image-wise exposure of the photosensitive layer proceeded as described in Example 1 but lasted 45 s. After the exposure the adhesive tape overall adhering to the photosensitive layer was peeled apart at room temperature. A same image result as described in Example 1 was obtained.

Example 9

Example 8 was repeated with the difference, however, that 0.01 g of compound 8 of Table 4 was replaced by

0.1 g of 4-methoxy-α-naphthol. The image-wise photoexposure proceeded as in Example 1 but lasted only 10 s. The laminating and stripping (peeling apart) proceeded likewise as described in Example 1 and offered an analogous result.

Example 10

To the aluminium layer of the support of Example 1 a photosensitive layer was applied at a wet coating thickness of 50 µm from a solution containing the following ingredients :

| | |
|---|---|
| carbon tetrabromide | 0.2 g |
| compound 20 of Table 6 | 0.1 g |
| copolymer of vinyl chloride/vinyl acetate/maleic anhydride (86/13/1 weight %) | 1 g |
| methyl ethyl ketone | 26 ml |

After drying at 80°C for 5 min a transparent adhesive tape as described in Example 1 was laminated on the photosensitive layer. The image-wise exposure of the photosensitive layer proceeded as described in Example 1. After the exposure the adhesive tape overall adhering to the photosensitive layer was peeled apart at room temperature. A same image result as described in Example 1 was obtained.

Example 11

To the aluminium layer of the support of Example 1 a photosensitive layer was applied at a wet coating thickness of 50 µm from a solution containing the following ingredients :

| | |
|---|---|
| carbon tetrabromide | 0.1 g |
| compound 20 of Table 6 | 0.05 g |
| polycarbonate of 2,2-(4,4'-dihydroxyphenyl)-propane | 0.5 g |
| 1,2-dichloroethane | 13 ml |

After drying at 80°C for 5 min the photosensitive layer was image-wise exposed as described in Example 7.

After the image-wise photoexposure an adhesive tape as defined in Example 1 was laminated to the photosensitive layer. The adhesive tape overall adhering to the photosensitive layer was peeled apart at room temperature. A negative aluminium image was obtained on the support and a positive image on the photosensitive layer peeled apart with the tape.

Example 12

Example 11 was repeated with the difference, however, that compound 20 of Table 6 was replaced by the same amount of 1',3',3'-trimethyl-spiro[2H-1-benzopyran-2,2'-indoline].

After effecting the image-wise exposure and peel apart processing as described in Example 11 a same image result was obtained.

CLAIMS :

1. Recording material for the production of metallic images by information-wise photoexposure and peel-apart processing, which material comprises a support carrying a metal layer in adhering contact therewith, the said metal layer being covered on its outer surface in adhering contact with a photosensitive binder layer that undergoes a reduction in adhering power towards the said metal layer on exposure to actinic light, the adherence of said metal layer towards said photosensitive layer in unexposed state being stronger than towards said support so that, by overall peeling-apart of the thus exposed photosensitive layer from the said support, said metal layer can be detached from the support in areas corresponding to unexposed areas of the said photosensitive binder layer, but is otherwise left adhering onto the support, characterized in that the binder of the said photosensitive layer consists of or contains :

(1) a photosensitive material that is capable of releasing $CO_2$ gas on exposure to actinic radiation and/or

(2) a photosensitive material that is capable of yielding a hydrohalic acid on exposure to actinic radiation.

2. Recording material according to claim 1, characterized in that the said photosensitive binder layer contains as photosensitive $CO_2$-releasing material an organic compound containing at least one oxime ester group of the structure $-\overset{|}{C}=N-O-CO-R$, wherein R is an organic group.

3. Recording material according to claim 2, characterized in that the organic compound containing at least one oxime ester group corresponds to one of the general formulae :

$$R^5 - \overset{\displaystyle R^4}{\underset{}{\overset{|}{C}}} = N - O - R^6$$

and

$$R^5 - \overset{\displaystyle R^4}{\overset{|}{C}} = N - O - R^7 - O - N = \overset{\displaystyle R^4}{\overset{|}{C}} - R^5$$

wherein :

$R^4$ represents an alkyl group containing 1 or 2 carbon atoms, an aryl group, an alkaryl group, an aralkyl group, a hydroxy-substituted aralkyl group, or an acyl group including a substituted acyl group,

$R^5$ represents one of the groups of $R^4$ or a hydrogen atom,

or wherein $R^4$ and $R^5$ together represent the necessary atoms to form with the adjacent carbon atom a cycloalkyl group, a phenanthrone group, or an indanone group,

$R^6$ represents an acyl group including a substituted acyl group, and

$R^7$ represents a diacyl group.

4. Recording material according to claim 1, characterized in that the said photosensitive material capable of photochemically producing a hydrohalic acid comprises a compound capable of photochemically forming halogen radicals on exposure to actinic radiation and a compound acting as hydrogen donor when reacting with said photochemically formed halogen radicals.

5. Recording material according to claim 4, characterized in that the said compound capable of photochemically forming halogen radicals is a homo-polymer or a co-polymer of halogenated $\alpha,\beta$-ethylenically unsaturated monomer(s).

6. Recording material according to claim 5, characterized in that the said homo-polymer or co-polymer contains vinyl chloride and/or vinylidene chloride units.

7. Recording material according to claim 4, characterized in that the said compound capable of photochemically forming halogen radicals corresponds to the general formula :

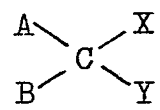

wherein :
each of A, B, X and Y are chlorine, bromine or iodine, or wherein one of said radicals A, B, X or Y represents an alkyl group including a substituted alkyl group, an aryl group including a substituted aryl group or an aroyl group and the other radicals represent chlorine, bromine or iodine, or wherein one or two of said radicals A, B, X or Y represent an aromatic acyl group and the other radicals represent chlorine, bromine or iodine.

8. Recording material according to any of claims 4 to 7, characterized in that the said material capable of yielding a hydrohalic acid contains a sensitizing agent for increasing the production of halogen radicals on exposure and/or acting as hydrohalic acid acceptor by salt formation.

9. Recording material according to any of claims 1 to 8, characterized in that the said metal layer is an aluminium layer and the said support is a polyethylene terephthalate support.

10. Method for the production of metal images characterized in that said method comprises the steps of :
(1) information-wise photoexposing the photosensitive binder layer of the recording material of any of the claims 1 to 9 to actinic radiation up to a dosage wherein the adhesion of the exposed parts of the photosensitive layer to said metal layer becomes smaller than the adhesion of the support to said metal layer, and

(2) peeling-apart the photosensitive binder layer to detach the metal layer from the support in the non-exposed portions leaving parts of said metal layer corresponding with the photoexposed parts of the photosensitive layer on the support.

European Patent Office

# EUROPEAN SEARCH REPORT

0042632

Application number

EP 81 20 0490

| Category | DOCUMENTS CONSIDERED TO BE RELEVANT<br>Citation of document with indication, where appropriate, of relevant passages | Relevant to claim |
|---|---|---|
| D | DE - A - 2 716 422 (KOMOTO)<br>* figures; claims *<br>& NL - A - 77 04 083<br>& US - A - 4 205 989<br>-- | 1 |
| | DE - A - 2 824 083 (POLYCHROME)<br>* claims *<br>& NL - A - 78 01 898<br>& FR - A - 2 373 343<br>-- | 1 |
| | GB - A - 2 020 839 (POLYCHROME)<br>* claims; figures *<br>-- | 1 |
| | GB - A - 2 020 838 (POLYCHROME)<br>* claims; figures *<br>-- | 1 |
| | GB - A - 2 020 837 (POLYCHROME)<br>* claims; figures *<br>-- | 1 |
| | GB - A - 2 020 836 (POLYCHROME)<br>* claims; figures *<br>-- | 1 |
| | US - A - 4 142 898 (I. MASATSUGU)<br>* claims *<br>-- ./. | 1,4,7 |

CLASSIFICATION OF THE APPLICATION (Int. Cl.[3])

G 03 F 1/00
7/10
G 03 C 5/00

TECHNICAL FIELDS SEARCHED (Int. Cl.[3])

G 03 F 1/00
7/10
G 03 C 5/00

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

✓ The present search report has been drawn up for all claims

| Place of search | Date of completion of the search | Examiner |
|---|---|---|
| The Hague | 20-08-1981 | RASSCHAERT |

EPO Form 1503.1 06.78

European Patent Office

# EUROPEAN SEARCH REPORT

Application number EP 81 20 0490



| DOCUMENTS CONSIDERED TO BE RELEVANT | | | CLASSIFICATION OF THE APPLICATION (Int. Cl.3) |
|---|---|---|---|
| Category | Citation of document with indication, where appropriate, of relevant passages | Relevant to claim | |
| A | GB - A - 1 378 970 (H.A. FROMJOU)<br>* claims; page 2, lines 106-109 *<br>& US - A - 3 839 037<br>-- | 1,4,7 | |
| A | FR - A - 2 330 033 (SEAL)<br>* claims *<br>& US - A - 4 081 282<br>& US - A - 4 145 216<br>------- | 1 | |
| | | | TECHNICAL FIELDS SEARCHED (Int. Cl.3) |